Europäisches Patentamt

European Patent Office

Office européen des brevets

(11) Publication number: **0 243 850**
**A2**

(12) **EUROPEAN PATENT APPLICATION**

(21) Application number: 87105835.0

(22) Date of filing: 21.04.87

(51) Int. Cl.⁴: **H01L 21/76**

(30) Priority: 29.04.86 US 857043

(43) Date of publication of application:
04.11.87 Bulletin 87/45

(84) Designated Contracting States:
DE FR GB NL

(71) Applicant: **TEKTRONIX, INC.**
**Tektronix Industrial Park D/S Y3-121 4900**
**S.W. Griffith Drive P.O. Box 500**
**Beaverton Oregon 97077(US)**

(72) Inventor: **Yamaguchi, Tadanori**
**5612 S.E. Drake Street**
**Hillsboro Oregon 97123(US)**
Inventor: **Drosd, Robert M.**
**19370 S.W. Blanton Street**
**Aloha Oregon 97007(US)**

(74) Representative: **Strasse, Joachim, Dipl.-Ing. et**
**al**
**Strasse und Stoffregen European Patent**
**Attorneys Zweibrückenstrasse 17**
**D-8000 München 2(DE)**

(54) Selective epitaxial layer field oxide (sel-fox) isolation.

(57) The invention is a field oxidation process which commences by patterning and etching a silicon substrate to form recessed field regions surrounding spaced-apart, elevated active device regions. Then, a shield layer, e.g., of nitride, is applied over the top and sidewalls of the elevated active device regions. Then, the silicon surface is exposed in the recessed field regions. Next, an epitaxial layer of additional silicon is deposited selectively on the exposed silicon substrate in the recessed field regions. The shield layer material and the conditions of deposition of the epitaxial layer are selected to prevent deposition of silicon on the active regions. The epitaxial silicon deposited in the recessed field regions is then oxidized to form the field oxide. If desired, an additional thickness of the underlying substrate silicon may be oxidized contiguously with the epitaxial layer. This process can be used to fabricate either bipolar or MOS devices.

## SELECTIVE EPITAXIAL LAYER FIELD OXIDE (SEL-FOX) ISOLATION

BACKGROUND OF THE INVENTION

This invention relates to processes for forming field oxide isolation structures in integrated circuits, and more particularly, to an improved method of forming a bird's beak free field oxide layer.

The best known and most widely used technique for providing field oxide isolation structures in integrated circuits is known as the LOCOS technique, several variations of which are described in Appels, et al., "Local Oxidation of Silicon; New Technological Aspects," Philips Research Reports, June 1971, Vol. 26, No. 3, pages 157-165. LOCOS is an abbreviation for "local oxidation of silicon." Appels, et al. describe three LOCOS procedures. In each, an area of the silicon substrate which is intended to be used as an active device region is covered with a thin (e.g., 1500Å) $Si_3N_4$ ("nitride") layer, which is patterned to define the active device region. Subsequent thermal oxidation converts the exposed silicon to silicon dioxide ("oxide") all around the nitride pattern. During oxidation, the thickness of the oxide layer grows upward from the substrate surface as well as downward into the silicon. In the simplest form of the LOCOS technique, the final active region is recessed between the field oxide regions. In alternate forms of the LOCOS technique, the silicon is selectively etched around the nitride pattern to produce a more nearly planar, or full-recessed, field oxide structure. In all of these variations of the LOCOS technique, the growth of oxide intrudes a distance beneath the margins of the nitride pattern that is approximately equal to the thickness of the oxide layer.

This intrusion of oxide beneath the nitride layer forms what is known in the art as a bird's beak structure. This structure is better seen in Chiu, et al., "A Bird's Beak Free Local Oxidation Technology Feasible for VSLI Circuits Fabrication," IEEE Transactions on Electron Devices, Vol. ED-29, No. 4, April 1982, pages 536-540. Chiu, et al. propose an improvement in the LOCOS technique, referred to as the sidewall masked isolation (SWAMI) process.

A variation of the SWAMI process is disclosed in U.S. Pat. No. 4,477,310 to Park et al. and related U.S. Pat. No. 4,486,266 to Yamaguchi.

The SWAMI process is intended to eliminate the reduction in effective active region width due to oxide intrusion beneath the nitride pattern that is normally associated with the LOCOS process. The SWAMI process is generally similar to the variations in the LOCOS process which call for etching away a thickness of the silicon around the nitride pattern and then thermal oxidizing the exposed silicon. However, intermediate steps of deposition of nitride and reactive plasma etching of the nitride layer to form nitride sidewalls on the elevated active region are performed prior to the oxidation step. The nitride sidewalls help shield the margins of the active region from oxidation. Although successful to some extent in minimizing the bird's beak development, the SWAMI process produces a nonplanar substrate surface upon removal of the nitride layers. In particular, a notch or channel is formed around the active region. To fill this channel, a layer of oxide is chemical vapor-deposited on the substrate, including over the active region after removal of the nitride, and is then etched back, to planarize the substrate surface.

Another technique for forming field oxide isolation regions is disclosed in Shibata, et al., "A Simplified BOX (Buried-Oxide) Isolation Technology," Technical Digest of the 1983 IEDM, December 1983, pages 27-30. The BOX process is generally similar to the LOCOS processes in which the field oxide regions are recessed, except that instead of thermally growing field oxide, oxide is chemical vapor-deposited over the entire substrate and then etched back to expose the active regions. In order to planarize the substrate, additional masking and etching steps are performed to fill the recesses replicated in the CVD $SiO_2$ layer from the recesses in the substrate structure.

Yet another field oxide isolation process is disclosed by Endo, et al., "CMOS Technology Using SEG Isolation Technique," Technical Digest of the 1983 IEDM, December 1983, pages 31-34. The SEG (selective epitaxial growth) isolation technique inverts the procedure used in the LOCOS, SWAMI and BOX processes. Instead of masking the active device regions and then oxidizing the field regions, the entire substrate surface is oxidized and then masked and etched to expose the silicon in the active device regions. Then, the silicon is chemical vapor-deposited selectively on the exposed substrate surface to grow an epitaxial silicon layer in the active device regions. Epitaxial growth is continued until the surfaces of the epitaxial layers are substantially aligned with the surfaces of the oxide regions. Although on the face of it, this technique provides epitaxial regions of well defined dimensions without intrusion of bird's beak structure, it has a number of drawbacks not disclosed in the Endo, et al. paper.

First, the active device region is not ordinarily planar. Faceting occurs during epitaxial growth of the silicon. Although a central portion of the active device region can be made substantially coplanar with the field oxide surface, a V-shaped notch commonly forms along the edges of the active device region due to faceting. The depth of this notch has been found to vary with the orientation of the device pattern on the substrate surface. In some orientations, the depth of the notch can be as much as half of the thickness of the epitaxial layer. The resultant surfaces of active device regions are substantially nonplanar and the usable device area of such regions is effectively reduced.

A second problem with the SEG isolation technique is that the epitaxial silicon commonly has crystalline defects which propagate upward through the epitaxial layer as it is grown. These defects disadvantageously increase leakage current in the active devices.

Accordingly, a need remains for a method of providing field oxide isolation on integrated circuits, which is not only bird's beak free, but provides a substantially coplanar surfaces over the entire active device and field oxide regions, provides a defect-free crystalline structure in the active regions, and makes substantially the entire surface area of the active device region available for fabrication of circuit devices.

## SUMMARY OF THE INVENTION

One object of the invention is to provide an improved, bird's beak free, field oxide :solation technique.

Another object of the invention as aforementioned is to provide a substantially planar substrate surface, in which the entire area of the active device region is available for use of the construction of a circuit device.

A further object is to provide the foregoing bird's beak free, planar structure without impairing the crystallographic integrity of the active device region semiconductor material.

Yet another object is to provide the aforementioned planarity without resort to subsequent planarizing deposition and etching procedures.

The invention is a field oxidation process which commences by etching the substrate to form recessed field regions surrounding spaced-apart, elevated active device regions. Then, a shield layer, e.g., of nitride, is applied over the top and sidewalls of the elevated active device regions. Then, the silicon surface is exposed in the recessed field regions. Next, an epitaxial layer of additional silicon is deposited selectively on the exposed silicon substrate in the recessed field regions. The shield layer material and the conditions of deposition of the epitaxial layer are selected to prevent deposition of silicon on the active regions. The epitaxial silicon deposited in the recessed field regions is then oxidized to form the field oxide. If desired, an additional thickness of the underlying substrate silicon may be oxidized contiguously with the epitaxial layer.

Because the epitaxial layer is grown in the field area rather than the active device region, the quality of silicon deposition is not critical. The epitaxial layer of silicon is subsequently consumed by thermal oxidation. The sidewalls and top of the active device regions are protected by the shield layers so that there is neither nucleation of the epitaxial layer material nor lateral encroachment of oxide into the active device region. The surface of the active region is planar so that the entirety of such region is available for forming circuit devices. Notching along edges of the epitaxial layer can be minimized by selecting the orientation of the sidewalls of the active device regions to minimize faceting. Moreover, subsequent thermal oxidation of the epitaxial layer, which causes such layer to grow in elevation relative to the surface of the active device region, tends to obscure the effects of such faceting when the epitaxial layer is oxidized. The epitaxial layer is preferably deposited to a thickness, for example, of half of the depth of the recessed regions, so that oxidation raises the surface of the field oxide regions to substantially the same plane as the substrate surface under the top shield layer. Subsequent etching procedures, to remove the top shield layer and thereby expose the surface of the active regions, tend to further planarize the substrate surface, preparatory to forming a circuit device thereon.

The foregoing and other objects, features and advantages of the invention will become more readily apparent from the following detailed description of a preferred embodiment of the invention, which proceeds with reference to the accompanying drawings.

## BRIEF DESCRIPTION OF DRAWINGS

Fig. I shows the process of the present invention as used to fabricate a bipolar device having isolation trenches in the field oxide regions.

Fig. 2 is an illustration of the process of the present invention as used to fabricate a CMOS device.

Fig. 3 illustrates a variation of the process of the present invention.

## DETAILED DESCRIPTION

Referring to Fig. I, the substrate I0 is preferably a CZ <I00> P-type monocrystalline silicon wafer with a I.3 $\mu$m. epitaxial silicon layer I2. The epitaxial layer has a buried N+ doped layer I4 in contact with the P-substrate. Isolation trenches 20 are formed within the intended field oxide regions, to a depth extending well into the substrate I0. The structure and method of making the deep isolation trenches is described in U.S. Pat. Nos. 4,477,3I0 and 4,486,266. In subsequent patterning steps, the device pattern is oriented on the wafer surface so that feature sidewalls are parallel to the [I00] direction.

Referring to Fig. I(b), a stress relief oxide film I6 (500Å) is thermally grown on the top of reference surface I8 of the epitaxial layer I2. Then, a silicon nitride film 22 is deposited. Active device regions 24, 26 are then defined using conventional photolithographic techniques to mask the active regions with a layer 28 of patterned photoresist. The silicon nitride and stress-relief oxide films and the N-type epitaxial silicon layer in the field regions 30 are etched anisotropically using reactive-ion etching (RIE). The preferred gases for this step are $CHF_3$ + $H_2$ for the silicon nitride and silicon dioxide layers I6, 22 and $SiCL_4$ for the silicon epitaxial layer I2. The epitaxial layer is etched down to approximately the top of the buried N+ doped layer I4. Reactive ion etching is used to obtain sidewalls 32 on the active regions that are substantially normal to the epitaxial silicon surface 34 in the field regions.

Proceeding to Fig. I(c), the photoresist film is stripped, another thermal oxide film 36 is grown on surfaces 32, 34, and a second silicon nitride layer is chemical vapor-deposited over the entire wafer, including the sidewalls of the active regions. A second reactive ion etching step is performed to form nitride sidewalls 38, by removing the silicon nitride layer from atop the active regions and removing both the silicon nitride and silicon dioxide stress relief layer from the field regions 30. A new epitaxial silicon surface 40 is thereby exposed in the field regions 30. The active regions are thereby capped by the silicon nitride top shield layer 22 and sidewall shield layer 38.

Next, referring to Fig. I(d), an epitaxial layer 42 of intrinsic silicon is selectively chemical vapor-deposited on surfaces 40. Selective growth of layer 42 only on surfaces 40 is accomplished by controlling the conditions of deposition. Deposition conditions which yield such selective deposition are 950°C, 50-60 Torr., using a gas ratio of 400:4:I of $H_2$:HCl:dichlorosilane (see references I, 3 and 4). The addition of HCl to the gas mixture improves selectivity and also reduces defect density in the epitaxial layer. In this embodiment, the thickness of epitaxial layer 42 is targeted to a thickness sufficient to half fill the recessed field region 30, for example, about one minute of growth yields a thickness of about 4,000Å where surface 40 is recessed about 7,000-8,000Å below active device region surface I8. Orienting the feature sidewall parallel to the [I00] direction, as above mentioned, minimizes faceting of the epitaxial layer (see reference 2).

Referring to Fig. I(e), a thermal oxidation step converts epitaxial layer 42 and a portion of the underlying substrate epitaxial layer I2 to silicon dioxide, denoted by reference numeral 42a. Meanwhile, the active device regions 24, 26 remain completely protected from thermal oxidation by the silicon nitride shield layers 22, 38. The surface silicon nitride layer 22 and the stress relief oxide film I6 are then etched away to ready the wafer for the remainder of the circuit fabrication process. After oxidation, the facet or notching due to faceting is about I500Å, which is only about I5% of the field oxide layer thickness.

Fig. I(f) shows a final form of bipolar device structure built on the wafer of Fig. I(e), incorporating the above-mentioned deep isolation trenches 20 and a self-aligned polysilicon emitter and base structure.

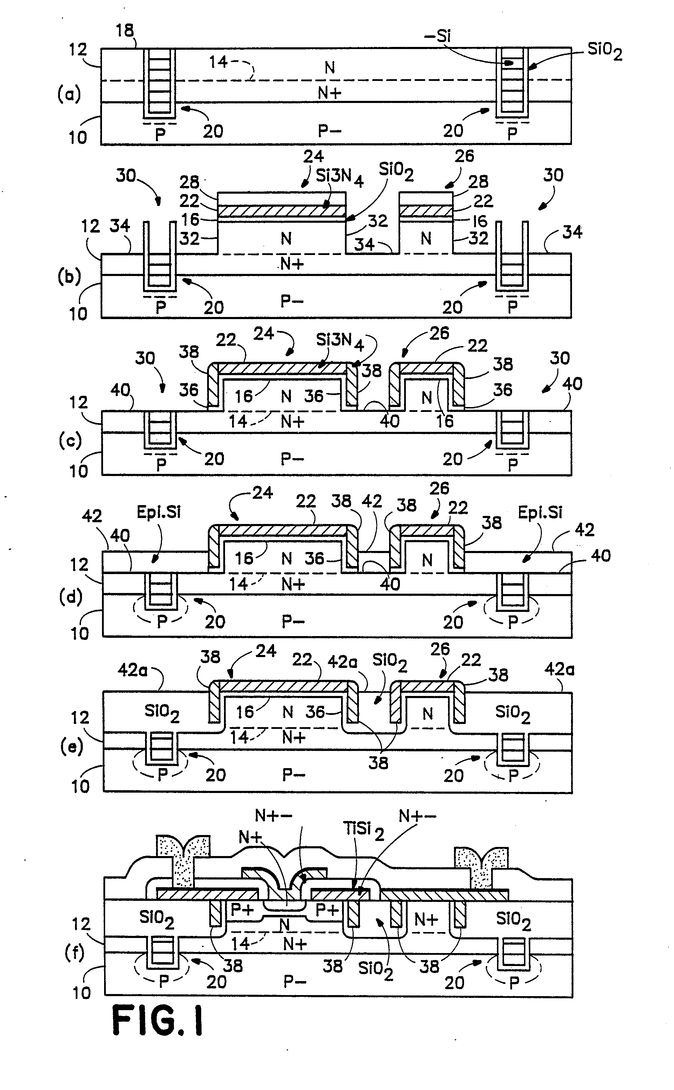

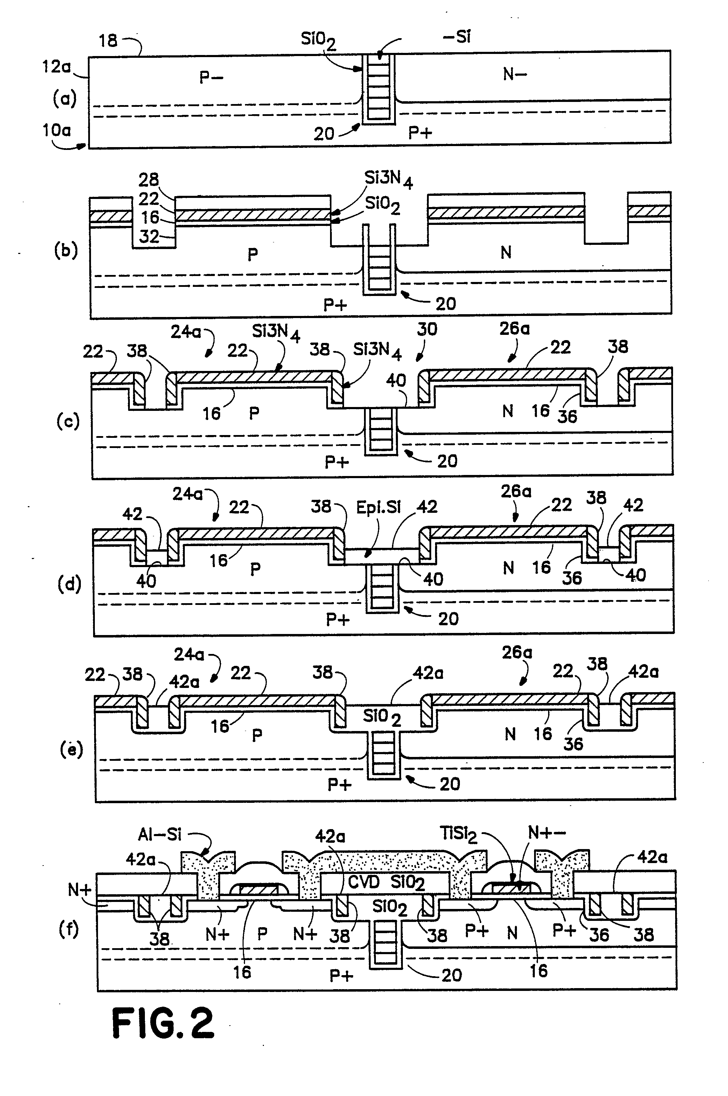

Figs. 2(a) through 2(f) illustrate application of the foregoing procedure to fabricate a CMOS device on a heavily doped P+ CZ <I00> silicon wafer I0a having a 3 $\mu$m. P-type epitaxial layer I2a. Except for the manner of doping and patterning the active regions for the particular type of device to be fabricated, the procedures illustrated in Figs. 2-(a) through 2(e) are substantially the same as those of Figs. I(a) through I(e), as illustrated by the use of like reference numerals to indicate like structures. The illustrative CMOS device is fabricated as described in U.S. Pat. No. 4,486,266.

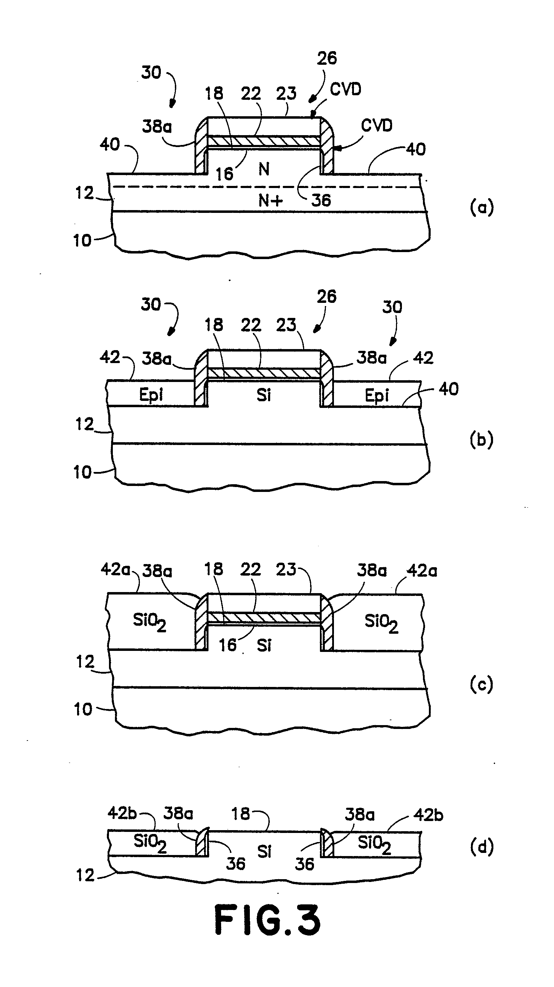

Fig. 3 illustrates a variation in the foregoing process, which can enhance planarization of the substrate surface upon completion of the field isolation procedure.

Referring to Fig. 3(a), which corresponds to the stage of development illustrated in Fig. I(b), following chemical vapor deposition of nitride layer 22, a layer 23 (I,500Å) of oxide is chemical vapor-deposited atop nitride layer 22. Oxide layer 23 forms a part of the top shield layer in subsequent steps of this variation of the process of the invention.

After patterning and masking to define the active regions 26, and reactive ion etching to recess the field regions 30, the second nitride layer is applied as in the procedure of Fig. I, but is spaced above nitride layer 22 by CVD oxide layer 23. Upon reactive ion etching to remove the second nitride layer from the top surfaces of the active and field regions, all that remains of such layer are sidewalls 38a, which extend above nitride layer 22 to cover the sidewalls of CVD oxide layer 23.

Referring to Fig. 3(b), silicon is selectively epitaxially deposited on the exposed surfaces 40 of the field regions, as previously described with reference to Fig. l(d). When depositing under the aforementioned conditions, little if any silicon is deposited on oxide layer 23.

Referring to Fig. 3(c), the epitaxial silicon layer 42 is thermally oxidized, as previously described. In this variation of the procedure, the recessed field regions 30 are approximately half filled with the epitaxial silicon and, upon oxidation, completely fill the recessed regions to the surface of CVD oxide 23. However, the thickness of the field oxide is substantially greater at the stage of Fig. 3(c) than in Fig. l(e), due to the additional thickness of the CVD oxide layer 23.

Referring to Fig. 3(d), etching to remove layers l6, 22, 23 and thereby expose active device region surface l8 also removes a substantial portion of a thickness of oxide layer 42a, leaving an oxide layer 42b of about l $\mu$m. thick. This sequence of steps further improves planarity of the final surfaces of the active device and field oxide regions.

The additional CVD oxide layer 23 and heightened sidewalls 38a also appear to better shield the active device region during CVD deposition of epitaxial silicon layer 42 and thermal oxidation of such layer.

Having illustrated and described the principles of our invention in several embodiments, it should be apparent to those skilled in the art that the invention may be modified in arrangement and detail without departing from such principles. We claim all variations and modifications coming within the spirit and scope of the following claims.

## References

l. A. Ishitani, N. Endo, H. Tusya, Jap J of Applied Physics, Vol. 23, No. 6, June l984, pp. L39l-393.

2. A. Ishitani, H. Kitajima, N. Endo, N. Kasai, Jap J of Applied Physics, Vol. 24, No. l0, October l985, pp. l267-l269.

3. H. Kitajima, A. Ishitani, N. Endo, K. Tanno, Jap. J of Applied Physics, Vol. 22, No. l2, December l983, pp. L783-L785.

4. K. Tanno, N. Endo, H. Kitajima, Y. Kurogi, H. Tsuya, Jap J of Applied Physics, Vo. 2l, No. 9, September l982, pp. L564-L566.

## Claims

1. A method for providing field oxide isolation on a surface of a substrate of a semiconductor material, comprising:

selectively covering predetermined, spaced apart areas of the substrate surface with a top shield layer, each of said areas defining an active device region surrounded by an exposed area of substrate material;

removing a predetermined thickness of the semiconductor material from the exposed areas to form recessed areas between the active device regions, the recessed regions being bounded by sidewalls of exposed semiconductor material of the active device regions;

covering the exposed sidewalls of the active device regions with a sidewall shield layer;

selectively depositing additional semiconductor material on the substrate within the recessed regions to fill said regions to a predetermined depth;

oxidizing the deposited semiconductor material to a second predetermined depth in the recessed regions so as to surround the active device regions with a field oxide; and

removing a portion of the shield layers to expose the active device regions;

the shield layers being formed of a material selected to shield the semiconductor material of the active device regions from deposition of the additional semiconductor material thereon and prevent oxidation thereof.

2. A method according to claim l in which the semiconductor material comprises silicon, the shield layer comprises silicon nitride, and the additional semiconductor material is silicon, epitaxially deposited in the recessed areas by chemical vapor deposition under conditions such that there is substantially no deposition thereof onto the silicon nitride.

3. A method according to claim 2 in which said deposition conditions include a gas ratio of about 400:4:l of $H_2$:HCl:dichlorosilane, a temperature of about 950°C, and a pressure of 50-60 Torr.

4. A method according to claim 2 in which the substrate comprises a silicon crystalline substrate having a <l00> surface orientation, including orienting the sidewalls substantially parallel to a [l00] direction on the substrate surface so that the epitaxial silicon is deposited with minimal faceting so that the resultant surface is substantially planar.

5. A method according to claim l in which the step of selectively covering the active device regions and removing semiconductor material to form recessed regions includes:

depositing the shield layer material over the entire surface of the substrate;

patterning and masking the active device regions; and

reactive ion etching the exposed areas to form said sidewalls substantially normal to the substrate surface.

6. A method according to claim I including:

forming the sidewalls of the active regions substantially normal to the substrate surface;

depositing a second layer of the shield material over the entire substrate including said sidewalls; and

reactive ion etching the second layer of shield material so as to remove same from all surfaces of the substrate except the sidewalls.

7. A method according to claim 6 including depositing a layer of oxide on the top shield layer, prior to deposition of the second shield layer, to separate the two shield layers and to extend said sidewalls upward along opposite sides of the layer of oxide.

8. A method according to claim I in which the steps of covering the semiconductor material of the substrate in the active device regions with said top and sidewall shield layers each include forming a thin, covering layer of oxide in contact with the substrate semiconductor material and removing said oxide within the recessed regions to expose the semiconductor material therein prior to deposition of said additional semiconductor material.

9. A method for providing field oxide isolation on a surface of a substrate of a semiconductor material, comprising:

providing a silicon substrate having a substantially planar surface;

selectively etching away a predetermined thickness of the substrate to define elevated regions bounded by sidewalls and spaced apart by surrounding recessed regions;

selectively covering the elevated regions including said sidewalls with a shield layer; and

chemical vapor depositing an epitaxial layer of silicon on the silicon substrate in the recessed regions; and

oxidizing the last-deposited epitaxial layer of silicon to form a field oxide.

10. A method according to claim 9 including forming the shield layer of a material such that silicon does not chemical vapor deposit thereon and which shields the covered silicon of the elevated regions from oxidation.

II. A method according to claim 10 including depositing the silicon under conditions such that there is substantially no deposition thereof on the shield layer.

I2. A method according to claim 9 in which selectively etching the substrate includes reactive ion etching the silicon anisotropically to form the sidewalls substantially normal to the substrate surface.

I3. A method according to claim 9 including removing portions of the shield layer to expose the planar surface of the silicon substrate in the elevated regions and fabricating an active device in each of the exposed regions, the devices being mutually isolated in the substrate by the field oxide.

I4. A method according to claim I3 in which the active device is a bipolar device.

I5. A method according to claim I3 in which the active device is an MOS device.

I6. A method according to claim 9 including forming an isolation trench in the recessed region.

FIG. I

**FIG. 2**

FIG.3